# EUROPEAN PATENT APPLICATION

(11) **EP 0 954 123 A1**
(43) Date of publication of application: **03.11.1999**
(21) Application number: 98401070.2
(22) Date of filing: 30.04.1998
(51) Int. Cl.: H04B 7/26, H04B 1/30, H03D 7/16

(54) **Base station transceiver for a radio communications system**

(71) Applicant: ALCATEL, 75008 Paris (FR)
(72) Inventor: Fernandez Duran, Alfonso, 28229 Villanueva del Pardillo Madrid (ES); Sanjuan Flores, Tomas, 28029 Madrid (ES)
(74) Representative: Feray, Valérie

(57) **Abstract**

This invention concerns a base station for a radio communications system which, with respect to existing base stations, increases the traffic capacity and/or the communications quality. The base station consists of at least one antenna (11) and at least one transmitter/receiver (12) which incorporates a reception module (13) capable of receiving the signals transmitted by a number of terminals. The reception module (13), in turn, incorporates an image rejection module which obtains the signals from two carrier frequencies from the set of carrier frequencies in the radio communications system, whereby the base station can establish two communications simultaneously with two terminals that are inside its range of coverage.

## Description

### OBJECT OF THE INVENTION

This invention concerns a transmitter-receiver, hereafter termed transceiver, for a base station in a radio communications system with time division duplex connection DDT, the traffic capacity of which is increased whereby the base station can establish several communications simultaneously, via radio, with a number of portable and/or fixed subscriber terminals which are within the area covered by the base station.

It is of special, but not exclusive, application to the digital enhanced cordless telecommunications system, DECT, which is a mixed system using frequency division multiple access FDMA and time division multiple access TDMA.

### STATE OF TECHNOLOGY

A base station in a radio communications system is known for example, through the request for patent WO 95/06369 "A METHOD FOR ADDING CAPACITY TO A BASE STATION" and incorporated by reference herein.

In this request for patent the base station includes three transmitter-receivers or transceivers, which transmit and receive radio signals by means of two antennas. When one of the transceivers generates a message to be transmitted to a subscriber terminal which is within the area of coverage of the base station, the message is sent via an antenna after passing through a combiner element, of which there is one per antenna. Thus, there are two transceivers each of which has allocated to it an antenna and a combiner element.

However, the third transceier transmits its messages via one of the antennas mentioned, the antenna via which it transmits its message being assigned in a power divider.

The increase in base station capacity is due to the increase in the number of transceivers with which the base station is equipped. However, since there is no increase in the number of antennas that it has, the base station includes a device to allocate an antenna to the extra transceiver at any given moment.

The increase in base station capacity is achieved by increasing the number of transceivers and incorporating a device to allocate an antenna at any given moment to the additional transceiver. Consequently the increase in base station circuitry entails an increase in its cost.

### CHARACTERISATION OF THE INVENTION

An object of the present invention is to increase the traffic capacity of a base station in a radio communications system, without this involving an increase in the number of transceivers per base station.

To this end, the architecture of the reception part incorporated in the base station transceiver has been modified.

The base station which incorporates the transceiver of the invention, doubles the traffic capacity of a normal base station and only has one antenna and one transceiver. Thus, it doubles the traffic capacity without substantially increasing the cost of the base station.

Thus, the performance of a base station with the transceiver of the invention is greater than that of a normal base station with one transceiver and one antenna since, to obtain a base station with twice the traffic capacity using normal base stations, it would be necessary to mount two normal base stations side by side.

The base station includes at least one transceiver and one antenna through which the base station can establish radio communications with a number of portable and/or fixed terminals within its range of cover.

The means of reception incorporated in the transceiver captures simultaneously the signals of two carrier frequencies from the set of carrier frequencies that the radio communications system has allocated to it. To do this, the reception part includes an image rejection module that transforms the image frequency of a carrier frequency into another carrier frequency valid for use in another simultaneous communication; consequently the image frequency is not suppressed.

### BRIEF FOOTNOTE TO THE FIGURES

A fuller explanation of the invention is given in the following description based on the figures attached in which:
- figure 1 shows a block diagram of a base station for a digital enhanced cordless telecommunications system, DECT, according to the invention,
- figure 2 shows a block diagram of a base station with antenna diversity and with a single transceiver according to the invention,
- figure 3 shows a functional block diagram of an image rejection module of the transceiver in accordance with the invention,
- figure 4 shows a block diagram of a base station without antenna diversity and with two transceivers according to the invention, and
- figure 5 shows a block diagram of a base station with antenna diversity and with two transceivers according to the invention.

### DESCRIPTION OF THE INVENTION

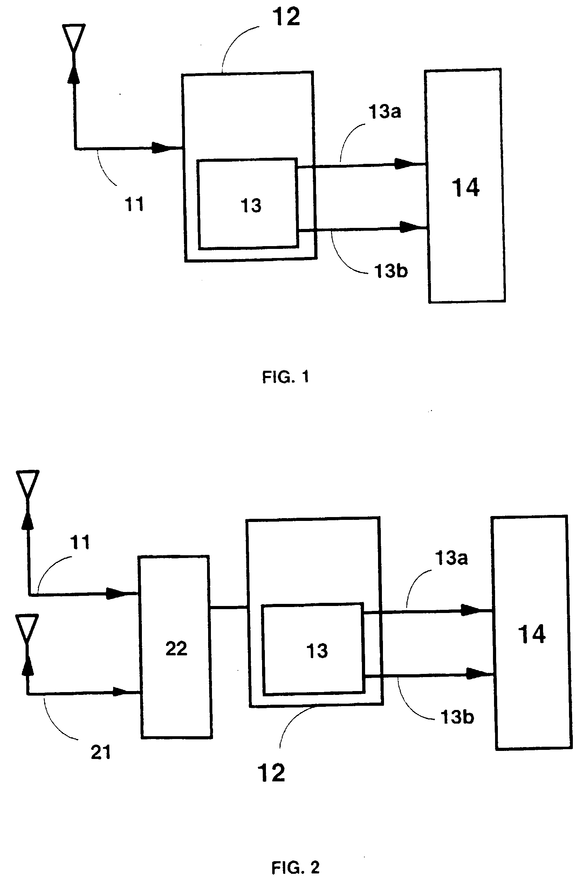

Figure 1 shows a block diagram of a base station for a digital enhanced cordless telecommunications system, DECT, in accordance with the invention.

The DECT system operates within a band of 20 MHz in the frequency range 1880 to 1900 MHz, using a time division multiplexed channel structure, with twelve digital channels sharing one carrier frequency from a set of ten different radiofrequency carriers. The DECT system is therefore a mixed system, using frequency division multiple access, FDMA, and time division multiple access, TDMA.

The base station includes an antenna 11 employed to receive and send radiofrequency signals constituting a telephone message. A transmitter-receiver 12 is connected to the antenna 11 to receive and demodulate, and to modulate and send, the radiofrequency carriers that have been previously modulated by a data signal.

The term transceiver is used hereafter to refer to a transmitter-receiver. The transceiver 12 includes a means of reception 13, which captures simultaneously the signals on two carrier frequencies F1, F2 from the set of ten carrier frequencies that are used in the DECT system.

The two carrier frequencies F1, F2 are received by a demodulator module 14 over two signal paths 13a, 13b; the telephone data signal being extracted from the carrier frequencies F1, F2 mentioned.

The reception part 13 includes an image rejection module 31, in which the two carrier frequencies F1, F2 are obtained.

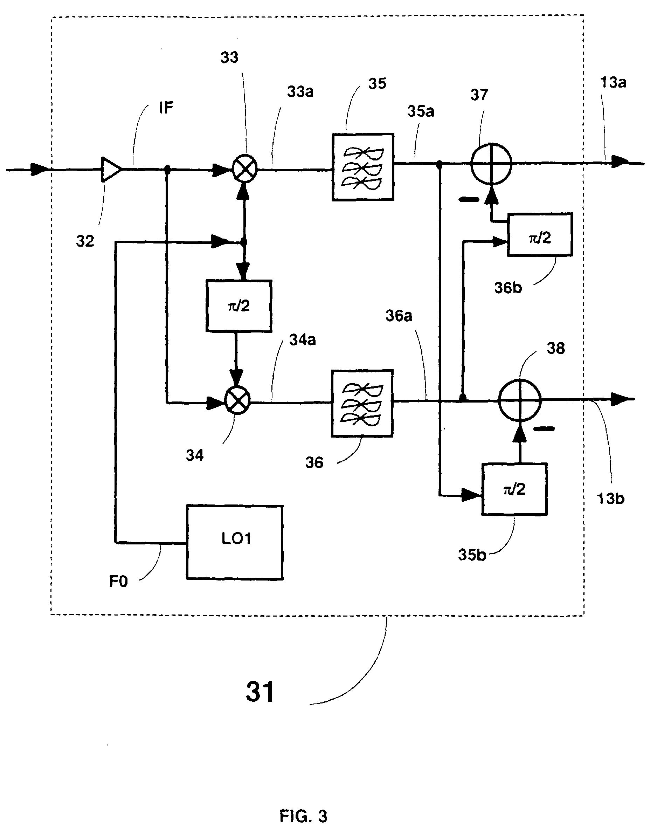

Figure 3 shows the internal architecture of the image rejection module 31. This rejection module 31 incorporates a frequency converter 32 which converts the received frequencies to an intermediate frequency IF.

Once the intermediate frequency IF has been obtained, it is applied to a pair of mixers 33, 34. A local oscillator LO1 generates an oscillator frequency F0 that is applied to the first mixer 33 and, also, after a phase shift of 90 º, to the second mixer 34.

At the outputs of the mixers 33, 34 two signals are obtained, one in phase and the other in quadrature, of the intermediate frequency. Each of the mixers 33, 34 is connected via a signal path 33a, 34a, to a bandpass filter 35, 36, where the signals coming from the mixers 33, 34 are filtered.

The frequency of oscillation F0 is chosen as a function of the two carrier frequencies it is desired to obtain and, specifically, it is the half-sum of the two carrier frequencies to be captured F1, F2. In this way the image frequency of a given frequency is converted into a carrier frequency by the image rejection module 31. Consequently this rejection module does not suppress the image frequency. In addition, the intermediate frequency IF is chosen so that it is the semi-difference of the two carrier frequencies to be captured F1, F2.

Each of the filters 35, 36 is connected to an adder 37, 38 via a signal path 35a, 36a. In each adder 37, 38, from the signal coming from the corresponding filter 35, 36 via signal paths 35a, 36a, the signal from the other signal path 36a, 35a is subtracted, after having passed through a phase shift adaptor module 35b, 36b, so that the separation between image frequencies is maximsed.

At the output of each adder 37, 38 a carrier frequency signal F1, F2, is obtained which is inside the set of ten DECT carriers. In this way the base station is able to support simultaneously two communications with a single transceiver 12 and one antenna 11.

The transceiver that the invention incorporates can be used in different base station configurations of a radio communcations system.

Figure 2 shows a base station that employs the space diversity method and therefore includes a second antenna 21.

A radio wave propagated between a transmitter and a receiver is attenuated when it traverses different objects such as walls, ceilings, partitions, trees, etc., and also by the signal reflections produced by such walls, trees, other buildings, and any kind of natural or artificial obstruction. To reduce this phenomenon, the base station is equipped with space diversity, that is, the base station is equipped with a second antenna 21, separated from the first antenna 11 by one half-wavelength.

When, because of reflection, the received signal at the first antenna 11 is minimum,. at the other it will be maximum. The base station also includes a switch 22, controlled by an algorithm that governs the change from the first antenna 11 to the second 21, and vice versa, in accordance with the received signal strength.

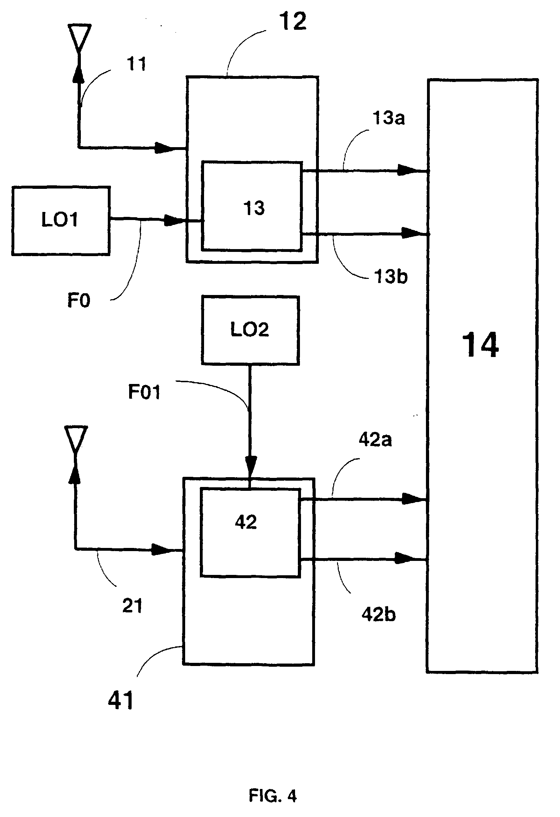

Figure 4 shows a base station without space diversity. Nevertheless, it includes two antennas 11, 21, each connected to a transceiver 12, 41 which, in turn, incorporate reception modules 13, 42 each of which includes an image rejection module 31 in accordance with the invention.

Each of these reception modules 13, 42 has in its corresponding image rejection module 31 an individual local oscillator LO1, LO2, each of which generates its own frequency of oscillation F0, F01, whereby they are not tuned to the same frequency of oscillation. Consequently each reception module 13,42, captures simultaneously the signals of two carrier frequencies F1, F2/F3, F4, from the set of ten different carriers in the DECT system and delivers to the demodulator 14 four different signals over four signal paths 13a, 13b, 42a, 42b, respectively.

Thus with this base station architecture it is possible to have four communications simultaneously.

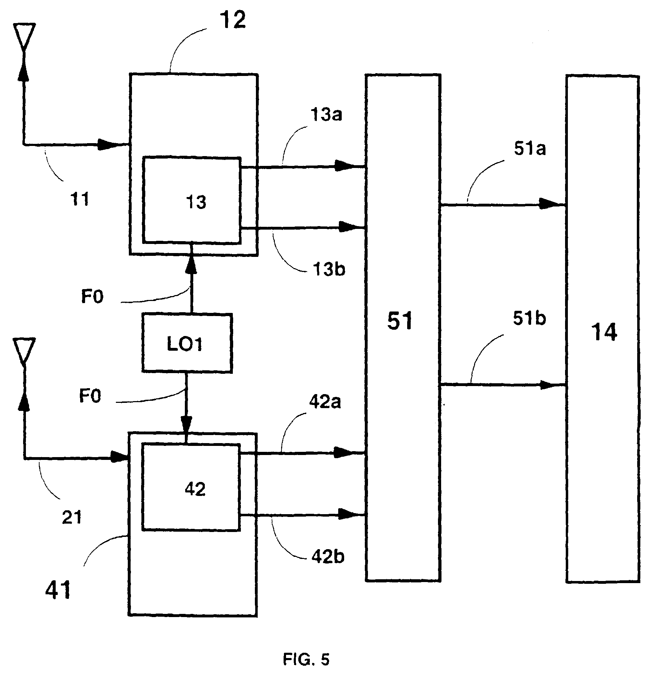

Figure 5 shows a base station that uses space diversity, incorporating two antennas 11, 21, two transceivers 12, 41, and also a selector module 51.

This selector module 51 is connected to both transceivers 12, 41 via four signal paths 13a, 13b, 42a, 42b, respectively. Over these signal paths, the selector module 51 receives the signals of two carrier frequencies F1, F2 repeated, since each reception element 13, 42 obtains the signals from the same pair of carrier frequencies F1, F2, that is, there are two signals with frequency F1 and two signals with frequency F2.

In this base station architecture the reception elements 13, 42 are tuned to the same frequency of oscillation, for example, to the frequency of oscillation F0 of the first local oscillator LO1. Therefore, the two reception elements 13, 42 capture the signals of the same pair of carrier frequencies F1, F2.

The selector module 51, by means of a control algorithm, performs a power level comparison of the two pairs of carrier frequency signals F1, F2 against a predetermined power level, selecting from between the carrier frequency pairs F1, F2, the one which has the higher level.

The base station with this configuration is only able to support simultaneously two communications, but offers better quality by using space diversity.

## Claims

1. **BASE STATION** of a radio communications system using time division duplex, DDT, in which the base station includes at least one transceiver (12), and at least one antenna (11), through which the base station can establish radio communications with a number of portable terminals that are within its range of cover, said transceiver (12) includes reception elements (13) which capture simultaneously the signals on two carrier frequencies (F1, F2), **characterised** in that the reception elements (13) include an image rejection module (31) which incorporates a local oscillator (LO1), the frequency of oscillation (F0) of which is a function of at least two of the carrier frequencies (F1, F2) of the set of carrier frequencies of the radio communications system.

2. **BASE STATION**, in accordance with claim 1, **characterised** in that the frequency of oscillation (F0) of the local oscillator (LO1) is equal to the half-sum of the two carrier frequencies (F1, F2) chosen.

3. **BASE STATION**, in accordance with claim 1, **characterised** in that it also incorporates a second antenna (21).

4. **BASE STATION**, in accordance with claims 1, **characterised** in that it also incorporates a second transceiver (41), identical to the first transceiver (12).

5. **BASE STATION**, in accordance with claims 3 and 4, **characterised** in that the second transceiver (41) includes second reception elements (42) that make use of the frequency of oscillation (F0) of the local oscillator (LO1) of the first transceiver (12).

6. **BASE STATION**, in accordance with claims 1 and 5, **characterised** in that the two recpetion elements (13, 42) capture the signals of the same pair of carrier frequencies (F1, F2); these signals being connected to a selector (51) which selects from each carrier frequency pair (F1, F2) the one with the higher level.

7. **BASE STATION**, in accordance with claim 5, **characterised** in that the second reception elements (42) capture the signals of two carrier frequencies (F3, F4) using a second local oscillator (LO2) with a frequency of oscillation (F01) different to the frequency of oscillation (F0) of the first transceiver (12).

8. **BASE STATION**, in accordance with any of the above claims, **characterised** in that it is the base station of a digital enhanced cordless telecommunications system, DECT.
